# EUROPÄISCHE PATENTSCHRIFT

(11) **EP 1 362 332 B1**
(45) Veröffentlichungstag und Bekanntmachung des Hinweises auf die Patenterteilung: **02.03.2005**
(21) Anmeldenummer: 02700209.6
(22) Anmeldetag: 31.01.2002
(51) Int. Cl.: G07F 1/00, H01L 29/423

(54) **ZEITERFASSUNGSVORRICHTUNG UND ZEITERFASSUNGSVERFAHREN UNTER VERWENDUNG EINES HALBLEITERELEMENTS**
TIME-DETECTION DEVICE AND TIME- DETECTION METHOD BY USING A SEMI-CONDUCTOR ELEMENT
DISPOSITIF DE DETECTION TEMPORELLE ET PROCEDE DE DETECTION TEMPORELLE FAISANT INTERVENIR UN ELEMENT A SEMI-CONDUCTEURS

(30) Priorität: 23.02.2001 DE 10108913
(43) Veröffentlichungstag der Anmeldung: 19.11.2003
(73) Patentinhaber: Infineon Technologies AG, 81669 München (DE)
(72) Erfinder: PALM, Herbert, 85635 Hoehenkirchen (DE); WOHLRAB, Erdmute, 81737 Muenchen (DE); TADDIKEN, Hans, 81737 Muenchen (DE)
(74) Vertreter: Stöckeler, Ferdinand, Dipl.-Ing.
(86) Internationale Anmeldenummer: PCT/EP2002/001013
(87) Internationale Veröffentlichungsnummer: WO 2002/069284

(56) Entgegenhaltungen:
- WO-A-01/17025
- US-A- 5 760 644
- PATENT ABSTRACTS OF JAPAN vol. 017, no. 105 (P-1495), 3. März 1993 (1993-03-03) & JP 04 294292 A (CITIZEN WATCH CO LTD), 19. Oktober 1992 (1992-10-19)

## Beschreibung

Die vorliegende Erfindung betrifft Zeiterfassungsvorrichtungen und Verfahren und insbesondere solche Zeiterfassungs-Vorrichtungen und -Verfahren, die zur Realisierung eines stromlosen Zeitnormals verwendet werden können, um beispielsweise eine Verzögerung der Zugriffszeit auf einen Chip zu ermöglichen.

Elektronische Schaltungen, beispielsweise Chipkarten-ICs, unterliegen einer besonderen Anforderung hinsichtlich der Abwehr von nicht-autorisierten Zugriffen. Um nicht-autorisierte Zugriffe zu verhindern, werden elektronische Schaltungen, die sicherheitsrelevante Funktionen ausüben, beispielsweise Chipkarten-ICs, unter Verwendung von Verschlüsselungsverfahren abgesichert. Um derartige Verschlüsselungsverfahren auszuforschen, kann die elektronische Schaltung mit nur graduell veränderten Signalmustern angesprochen werden, beispielsweise im Rahmen einer DPA (differential power analysis), wobei die elektronische Schaltung bei derartigen Angriffen periodisch ein- und ausgeschaltet wird. Ein erfolgreicher Angriff, der einen nicht-autorisierten Zugriff auf die elektronische Schaltung bzw. den Chipkarten-IC ermöglicht, erfordert eine gewisse Anzahl von Einschaltvorgängen. Dieser Angriff kann erschwert oder verhindert werden, indem die Zeit zwischen den Einschaltvorgängen verlängert wird, oder indem in einem vorgegebenen Zeitintervall nur eine bestimmte Anzahl von Einschaltvorgängen zugelassen werden.

Um die obigen Maßnahmen gegen nicht-autorisierte Zugriffe ergreifen zu können, ist es notwendig, eine Zeitmessung auf der elektronischen Schaltung bzw. dem Chip vorzusehen, die vorzugsweise auch im ausgeschalteten Zustand, d. h. ohne Energieversorgung, arbeitet. Darüber hinaus soll eine solche Zeitmessung weitgehend temperaturunabhängig und nicht von außen beeinflußbar sein.

Aus der US-5,760,644 ist eine integrierte Halbleiterschaltung bekannt, mittels derer ein Zeitablauf erfaßt werden kann. Gemäß der US-5,760,644 werden zu diesem Zweck Ladungsträger in ein Speicherdielektrikum eingebracht, wobei zur Zeiterfassung Änderungen des durch die in das Dielektrikum eingebrachte Ladung bewirkten elektrischen Felds verwendet werden. Dieses elektrische Feld ändert sich mit zunehmendem natürlichen Ladungsschwund in dem dielektrischen Material, so daß die Messung des elektrischen Feldes mit der Zeit Aussagen über eine verstrichene Zeit ermöglicht. Als Speicherdielektrikum wird gemäß der US-5,760,644 die ONO-Struktur (Oxid-Nitrid-Oxid-Struktur) eines SONOS-Transistors (Silizium-ONO-Silizium-Transistors) oder die NO-Struktur (Nitrid-Oxid-Struktur) eines SNOS-Transistors (Silizium-NO-Silizium-Transistors) verwendet. Bei Verwendung des ONO-Dielektrikums bzw. des NO-Dielektrikums der oben genannten Speichertransistoren wird der zeitabhängige Ladungsverlust der in Nitrid gespeicherten Elektronen durch die geänderte Einsatzspannung der Zelle nachgewiesen.

WO-01/17025 (Stand der Technik nach Art. 54.3 EPÜ) offenbart eine Zeiterfassungsvorrichtung wie definiert im Oberbegriff von Anspruch 1.

Die Aufgabe der vorliegenden Erfindung besteht darin, eine Vorrichtung und ein Verfahren zur Zeiterfassung zu schaffen, die eine weitestgehend temperaturunabhängige und von außen nicht beeinflußbare Realisierung eines Zeitnormals ermöglichen.

Diese Aufgabe wird durch eine Zeiterfassungsvorrichtung nach Anspruch 1 und ein Verfahren nach Anspruch 6 gelöst.

Erfindungsgemäß umfaßt eine Zeiterfassungsvorrichtung ein Halbleiterelement mit einer Transistorstruktur, beispielsweise in Form einer EEPROM-Zelle. Bei einer solchen EEPROM-Zelle ist über dem Kanalbereich des Speichertransistors ein Gate-Dielektrikum angeordnet, über dem eine Floating-Gate-Elektrode angeordnet ist, die von einer Steuer-Gate-Elektrode durch eine NO-Schichtfolge (Nitrid-Oxid-Schichtfolge) oder eine ONO-Schichtfolge (Oxid-Nitrid-Oxid-Schichtfolge) isoliert ist.

Erfindungsgemäß werden nun zur Zeiterfassung bzw. zur Realisierung eines Zeitnormals Ladungen in die Floating-Gate-Elektrode und von dort in die Nitridschicht der Isolierung zwischen Floating-Gate-Elektrode und Steuer-Gate-Elektrode injiziert, wobei sich nach einer solchen Injektion der Ladungsschwerpunkt der in die Nitridschicht injizierten Ladungen an der Grenzfläche zwischen der der Floating-Gate-Elektrode zugewandten Oxidschicht und der Nitridschicht der ON-Struktur bzw. der ONO-Struktur zwischen Floating-Gate-Elektrode und Steuer-Gate-Elektrode befindet.

Erfindungsgemäß wird nun zur Zeitmessung die Verschiebung des Ladungsschwerpunktes dieser injizierten Ladungen von der Grenzfläche weg genutzt, wobei diese Verschiebung einen Einfluß auf das Übertragungsverhalten des Kanalbereichs der Speicherzelle besitzt.

Abhängig von den für die Speicherzelle verwendeten Dotierungsarten können Elektronen oder Löcher in die ON-Schichtfolge oder die ONO-Schichtfolge injiziert werden, wobei zu Beginn die Ladungsträger in der Nähe ihrer Injektion lokalisiert sind, d. h. in der Nitridschicht an der Grenzfläche zwischen der der Floating-Gate-Elektrode zugewandten Oxidschicht und der Nitridschicht. Später beginnen diese Ladungsträger durch einen Trap-unterstützten Leitungsmechanismus, der als Hoppelleitung bezeichnet wird, durch das Nitrid zu wandern, so daß sich eine Verschiebung des Ladungsschwerpunkts ergibt. Diese Verschiebung des Ladungsschwerpunkts kann nun durch ein geeignetes Verfahren nachgewiesen werden, nämlich basierend auf Änderungen des Übertragungsverhaltens des Kanalbereichs der Speicherzelle, so daß das gewünschte Zeitnormal entsteht.

Bei einer EEPROM-Speicherzelle, wie sie erfindungsgemäß zur Zeitmessung verwendet wird, werden im Normalbetrieb Ladungen zur Speicherung von Informationen in die Floating-Gate-Elektrode injiziert, wobei die Ladungsinjektion in die ON-Isolationsschichtfolge bzw. die ONO-Isolationsschichtfolge lediglich ein unerwünschter Nebeneffekt ist. Erfindungsgemäß wird dieser Nebeneffekt zur Zeitmessung verwendet, wobei dieser Nebeneffekt proportional verstärkt auftritt, wenn mehr Ladungen in die EEPROM-Speicherzelle injiziert werden. Dieser Effekt kann zur Zeiterfassung genutzt werden, indem in eine Zeitmeßzelle eine größere Anzahl von Ladungen injiziert wird und in eine Referenzzelle eine geringere Anzahl von Ladungen injiziert wird, wobei die Ladungsmenge, die in die Zeitmeßzelle injiziert wird, ausreichend sein muß, um eine Injektion von Ladungen in die Nitridschicht zu bewirken. Bei Verwendung einer solchen Referenzzelle kann der Ablauf einer vorgegebenen verstrichenen Zeit dadurch erfaßt werden, daß die Einsatzspannung der Referenzzelle und der Zeitmeßzelle nach den entsprechenden Ladungsträgerinjektionen eine vorbestimmte Beziehung zueinander aufweisen, z.B. auf den gleichen Wert abgefallen'sind, wobei unter Einsatzspannung die an das Steuer-Gate anzulegende Spannung verstanden wird, die erforderlich ist, um einen vorbestimmten Stromfluß durch den Kanalbereich der jeweiligen Zelle zu bewirken.

Bevorzugte Ausführungsbeispiele der vorliegenden Erfindung werden nachfolgend bezugnehmend auf die beiliegenden Zeichnungen näher erläutert. Es zeigen:
- Fig. 1: schematisch den Aufbau einer EEPROM-Speicherzelle;
- Fig. 2: ein Diagramm, das die Einsatzspannung V_{E} über der Zeit für unterschiedliche Injektionsspannungshöhen zeigt; und
- Fig. 3: eine schematische Darstellung eines Ausführungsbeispiels einer erfindungsgemäßen Zeiterfassungsvorrichtung.

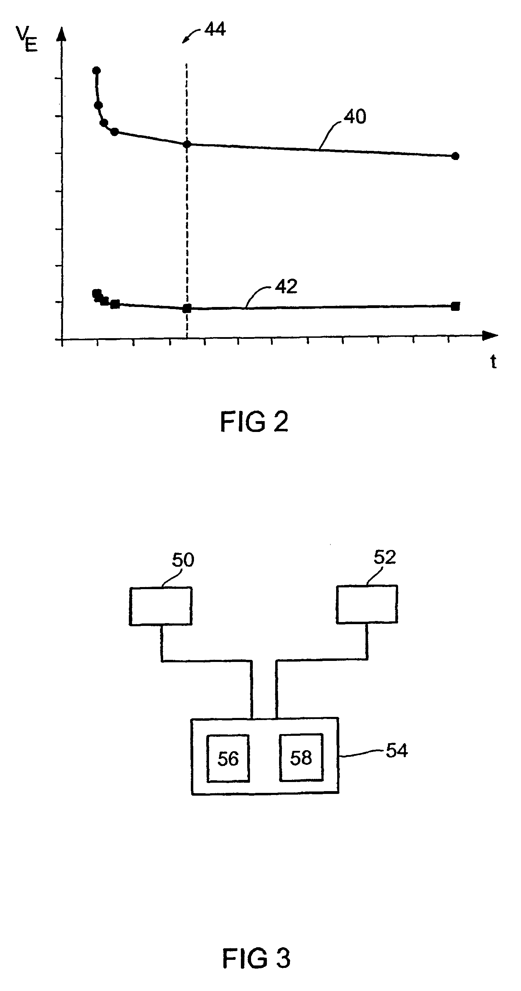

Bevor der der erfindungsgemäßen Zeiterfassung zugrundeliegende Effekt einer Ladungsschwerpunktverschiebung in der Nitridschicht eines Halbleiterelements mit einer Transistorstruktur, das bei bevorzugten Ausführungsbeispielen der vorliegenden Erfindung eine EEPROM-Speicherzelle ist, bezugnehmend auf die Fig. 2 und 3 näher erläutert wird, wird zunächst kurz auf den Aufbau einer solchen EEPROM-Speicherzelle eingegangen.

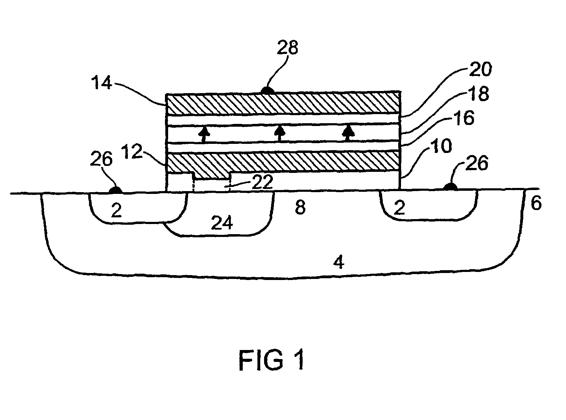

Fig. 1 zeigt eine schematische Querschnittansicht einer solchen EEPROM-Speicherzelle, bei der Source/Drain-Bereiche 2 durch entsprechende Implantationen in der dotierten Wanne 4 eines Halbleitersubstrats 6 vorgesehen sind. Über dem zwischen den Source/Drain-Bereichen angeordneten Kanalbereich 8 der Speicherzelle ist ein Gateoxid 10 vorgesehen, über dem eine Floating-Gate-Elektrode 12 angeordnet ist. Zwischen der Floating-Gate-Elektrode 12 und einer Steuer-Gate-Elektrode 14 ist eine ONO-Schichtfolge bestehend aus einer unteren Oxidschicht 16, einer Nitridschicht 18 und einer oberen Oxidschicht 20 vorgesehen.

Das Gateoxid 10, bzw. die Gateoxidschicht, besitzt einen Bereich 22 geringer Dicke, der ein Tunnelfenster darstellt. Unterhalb des Tunnelfensters 22 ist eine Injektionsimplantation 24 in der dotierten Wanne 4 vorgesehen. Schließlich sind die Source/Drain-Bereiche mit jeweiligen Source/Drain-Anschlüssen 26 und die Steuer-Gate-Elektrode mit einem Steuer-Gate-Anschluß 28 versehen.

Das Design der in Fig. 1 dargestellten EEPROM-Speicherzelle, bei der es sich um eine FLOTOX-Speicherzelle (FLOTOX = FLOating Gate Tunnel Oxide) handelt, bezüglich Dimensionierung, Dotierungskonzentrationen, Programmier- und Lösch-Spannungen und dergleichen kann weitgehend übereinstimmend mit herkömmlichen Strukturen einer Floating-Gate-Zelle gewählt sein. An dieser Stelle sei darüber hinaus angemerkt, daß neben der beschriebenen FLOTOX-Zelle andere Transistorstrukturen, die ein Floating-Gate aufweisen, beispielsweise bekannte Flashzellen, bei denen Elektronen durch Injektion von heißen Elektronen auf das Floating-Gate aufgebracht werden, verwendet werden können.

Der logische Zustand der in Fig. 1 gezeigten EEPROM-Speicherzelle bei Verwendung derselben als Speicher bestimmt sich durch den Ladungszustand des Floating-Gates 12. Um Ladungen auf die Floating-Gate-Elektrode 12 aufzubringen, d. h. in dieselbe zu injizieren, wird eine geeignete Injektionsspannung an den Steuer-Gate-Anschluß 28 angelegt, wodurch ein Fowler-Nordheim-Tunnel von Ladungsträgern durch das Tunnelfenster 22 auf die Floating-Gate-Elektrode 12 stattfindet. Die somit auf die Floating-Gate-Elektrode 12 aufgebrachten Ladungen beeinflussen das Übertragungsverhalten des Kanalbereichs 8, so daß sich die Einsatzspannung V_{E} ändert, d. h. die am Steuer-Gate-Anschluß 28 notwendige Spannung, um einen vorbestimmten Kanalstrom zwischen den Source/Drain-Bereichen 2, der über die Anschlüsse 26 abgegriffen werden kann, zu erhalten. Sind die verwendeten Dotierungen und Spannungen so, daß Elektronen auf die Floating-Gate-Elektrode 12 injiziert werden, verschiebt sich die Einsatzspannung mit zunehmender Anzahl von Ladungen auf der Floating-Gate-Elektrode zu zunehmend positiveren Spannungen.

Um die Speicherzelle zu lesen, d. h. den logischen Zustand der Zelle zu erfassen, wird in der Regel eine vorgegebene Spannung an die Steuer-Gate-Elektrode 28 angelegt, wobei der Kanalstrom dann ein Kriterium für den logischen Zustand der Zelle ist. Der Lesepegel, d. h. die zum Auslesen der Zelle an die Steuer-Gate-Elektrode anzulegenden Spannungen, müssen so gewählt sein, daß dadurch ein "Anprogrammieren" der Zelle auch nach einer Vielzahl von Lesezugriffen ausgeschlossen ist.

Wie oben erläutert wurde, werden somit im Normalbetrieb Ladungsträger auf die Floating-Gate-Elektrode der Speicherzelle injiziert. Neben dieser Injektion von Ladungsträgern in die Floating-Gate-Elektrode findet jedoch bei ausreichend hoher Injektionsspannung bzw. bei Verwendung einer ausreichend großen Anzahl von Spannungspulsen ferner eine Injektion von Ladungsträgern über einen Tunneleffekt durch die untere Oxidschicht 16 in die Nitridschicht 18 statt. Die so in die Nitridschicht 18 injizierten Ladungsträger sind zu Beginn in der Nähe ihrer Injektion, d. h. an der Grenzfläche zwischen unterer Oxidschicht 16 und Nitridschicht 18 lokalisiert. Nach Abschluß der Ladungsträgerinjektion und ohne Anlegen einer äußeren Spannung verschiebt sich dieser Ladungsschwerpunkt mit der Zeit in Richtung der Steuer-Gate-Elektrode 14, wobei diese Ladungsschwerpunktverschiebung im wesentlichen durch Hopping-Mechanismen (Poole-Frenkel Electron Hopping) bewirkt wird. Dieser Verschiebungsmechanismus ist in Fig. 1 in der Nitridschicht 18 durch Pfeile angezeigt und hält so lange an, bis durch das sich einstellende Gesamtfeld keine Ladungsträger bzw. Elektronen mehr bewegt werden können. Der Großteil der in das Nitrid injizierten Ladungen befindet sich dann an der Grenzfläche zwischen Nitridschicht 18 und oberer Oxidschicht 20.

Die in die Nitridschicht 18 injizierte Ladung hat neben der in das Floating-Gate 12 injizierten Ladung einen Einfluß auf das Kanalverhalten der Zelle. Je näher sich diese Ladungen am Kanal 8 der Zelle befinden, desto besser kann sie der Inversion des Kanals und damit dem Zustandekommen eines leitenden Kanals entgegenwirken. Die Nähe der Ladungen zum Kanal hat also einen direkten Einfluß auf die Einsatzspannung des Transistors bzw. der Speicherzelle. Diese Einsatzspannung ist somit abhängig von der örtlichen Lage des Ladungsschwerpunkts der Ladungen im Nitrid. Je näher sich dieser Schwerpunkt an der Steuer-Gate-Elektrode 14 befindet, desto höher liegt die Einsatzspannung der Zelle.

Da die oben beschriebene Ladungsverschiebung in der Nitridschicht 18 zeitabhängig stattfindet, kann dieselbe zur Zeiterfassung bzw. zur Realisierung eines Zeitnormals verwendet werden, indem die Ladungsverschiebung über eine Beobachtung der Einsatzspannung der Zelle überwacht wird.

In Fig. 2 sind die Einsatzspannungen V_{E} einer EEPROM-Zelle, wie sie oben beschrieben wurde, über der Zeit dargestellt, wobei die Kurve 40 die Einsatzspannung für Injektionsspannungen mit großer Pulshöhe zeigt, während die Kurve 42 die Einsatzspannung für Injektionsspannungen mit kleinerer Pulshöhe darstellt. Typische Injektionsspannungen, die bei typischen EEPROM-Zellen zu einem Kurvenverlauf 40 führen, besitzen beispielsweise eine Pulshöhe von 17 V, während Injektionsspannungen, die zu dem Kurvenverlauf 42 führen, beispielsweise eine Pulshöhe von 14 V aufweisen. Die Kurven 40 und 42 wurden bei Verwendung einer EEPROM-Zelle, deren untere Oxidschicht 16 eine Dicke von 5 nm aufwies, und deren Nitridschicht 18 eine Dicke von 20 nm aufwies, erhalten.

Die in Fig. 2 dargestellten Kurven 40 und 42 zeigen eine mit der Zeit abnehmende Einsatzspannung, wobei sich der Verlust an Einsatzspannung in zwei Phasen einteilen läßt. Die erste Phase zeigt ein schnelles Abklingen der Einsatzspannung, während danach ein kontinuierlicher Abfall der Einsatzspannung sichtbar ist, wobei die erste Phase im Bereich der gestrichelten Linie 44, die in Fig. 2 gezeigt ist, endet. Der schnelle Abfall in der ersten Phase ist durch die oben beschriebene Ladungsverschiebung in der Nitridschicht 16 bedingt, während für den kontinuierlichen Abfall in der zweiten Phase Leckströme verantwortlich sind. Erfindungsgemäß wird der schnelle Abfall der Einsatzspannung in der ersten Phase der Haltungskurven 40 und 42 zur Zeiterfassung genutzt. Dabei ist aus den Fig. 40 und 42 in Fig. 2 zu erkennen, daß dieser Effekt des Abfalls der Einsatzspannung mit zunehmender Pulshöhe der Injektionsspannung proportional verstärkt in Erscheinung tritt. Der Grund dafür liegt darin, daß die Pulshöhe der verwendeten Injektionsspannung das Verhältnis zwischen der Ladung, die auf das Floating-Gate injiziert wird, und der Ladung, die in die Nitridschicht injiziert wird, verändert. Je größer die Pulshöhe ist, desto größer wird der Anteil der Ladung, die in die Nitridschicht injiziert wird. Mit zunehmendem Anteil der Ladung, die in das Nitrid injiziert wird, nimmt der Einfluß der beschriebenen Ladungsverschiebung in der Nitridschicht auf den Verlauf der Einsatzspannung, wie er beispielsweise in Fig. 2 gezeigt ist, zu.

Es ist klar, daß erfindungsgemäß Injektionsspannungen verwendet werden müssen, die neben einem Ladungsträgertunneln durch das Tunnelfenster 22 ferner ein Tunneln durch die untere Oxidschicht 16 in die Nitridschicht 18 bewirken. Die Höhe der in der Praxis zu verwendenden Injektionsspannungen hängt dabei von dem jeweiligen Entwurf der Speicherzelle ab.

Werden entsprechende Injektionsspannungen verwendet, kann eine Zeiterfassung ohne weiteres basierend auf der Änderung der Einsatzspannung, die durch die beschriebene Ladungsverschiebung bedingt ist, erfolgen. Ein Ausführungsbeispiel, wie erfindungsgemäß der Ablauf einer vorbestimmten Zeit erfaßt werden kann, wird nachfolgend bezugnehmend auf Fig. 3 beschrieben. Bei diesem Ausführungsbeispiel werden eine Zeitmaßstabszelle 50 und eine Referenzzelle 52 verwendet, die beide beispielsweise den oben beschriebenen Aufbau einer Floating-Gate-Zelle mit einer ONO-Struktur als Interpolydielektrikum, d. h. als Dielektrikum zwischen Floating-Gate und Steuer-Gate, aufweisen. Die Zeiterfassungsvorrichtung umfaßt eine Steuereinrichtung 54, die zum einen eine Ladungsträgerinjektionseinrichtung 56 und zum anderen eine Einrichtung 58 zum Erfassen einer seit dem Injizieren von Ladungen in eine solche Floating-Gate-Zelle verstrichenen Zeit aufweist. Die Steuereinrichtung 54 ist in geeigneter Form mit der Zeitmaßstabszelle 50 und der Referenzzelle 52 verbunden.

Die Floating-Gate-Zellen beider Zellen 50 und 52 werden durch einen positiven Spannungspuls, der beispielsweise eine Höhe von 17 V aufweisen kann, an dem Steuer-Gate negativ aufgeladen, so daß die Einsatzspannung der Zellen positiv sind, d. h. beispielsweise einen Wert von 4 V besitzen. Das Floating-Gate der Zeitmaßstabszelle wird dann durch einen oder mehrere weitere Spannungspulse weiter negativ aufgeladen, beispielsweise auf eine Einsatzspannung von 5 V. Liegt keine Spannung mehr an den Zellen an, verschiebt sich durch das stärkere Feld in der Zeitmaßstabszelle 50 ihr Ladungsschwerpunkt in der Nitridschicht so, daß die Einsatzspannung der Zelle sinkt. Die Verwendung weiterer Spannungspulse besitzt eine vergleichbare Wirkung wie die Verwendung höherer Spannungspulse hinsichtlich der Ladungsverteilung zwischen Floating-Gate und Nitridschicht, so daß die ladungsverschiebungsbedingte Einsatzspannungsänderung bei der Zeitmaßstabszelle größer ist als bei der Referenzzelle. Als Zeitnormal kann nun beispielsweise die Zeit verwendet werden, bis die Einsatzspannung der Zeitmaßstabszelle wieder der der Referenzzelle entspricht, wobei dies durch einen Vergleich der Einsatzspannungen der beiden Zellen, der in der Einrichtung 58 durchgeführt wird, geschehen kann. Bei Verwendung der erfindungsgemäßen Zeiterfassungsvorrichtung als Schutzmechanismus vor nicht autorisierten Zugriffen kann der Chip dann beispielsweise erst wieder betrieben werden, wenn solche Übereinstimmung der Einsatzspannungen, bzw. ein vorbestimmtes Verhältnis der Einsatzspannungen zueinander, ermittelt wird.

Erfindungsgemäß wird somit eine Ladungsverschiebung in einer ON-Schicht bzw. einer ONO-Schicht als Zeitnormal verwendet, im Gegensatz zu bekannten Verfahren, beispielsweise dem in dem US-Patent 5,760,644 beschriebenen, bei dem eine natürliche Verflüchtigung von Ladungen in dem Speicherdielektrikum einer SONOS-Zelle zur Zeiterfassung genutzt wird. Die vorliegende Erfindung ermöglicht somit eine gegenüber bekannten Verfahren verbesserte Auflösung, da, wie oben beschrieben wurde, durch die Verwendung geeigneter Injektionsspannungspulse ein proportional erhöhter Einsatzspannungsabfall, der durch die beschriebene Ladungsverschiebung bewirkt wird, erreicht werden kann. Überdies ermöglicht die vorliegende Erfindung eine Zeitmessung, die weitestgehend temperaturunabhängig und von außen nicht beeinflußbar ist.

Bezüglich des bei der vorliegenden Erfindung zur Zeitmessung ausgenutzten Effekts der Ladungsverschiebung in der Nitridschicht einer EEPROM-Zelle sei auf die Diplomarbeit von Herrn Eric-Roger Brücklmeier "Untersuchungen zur Datenhaltung an FLOTOX-EEPROM-Zellen mit ONO als Interpolydielektrikum" mit Abgabetermin vom 1. Mai 1998 verwiesen.

### Bezugszeichenliste

- 2: Source-Drain-Bereiche
- 4: dotierte Wanne
- 6: Halbleitersubstrat
- 8: Kanalbereich
- 10: Gateoxid
- 12: Floating-Gate-Elektrode
- 14: Steuer-Gate-Elektrode
- 16: untere Oxidschicht
- 18: Nitridschicht
- 20: obere Oxidschicht
- 22: Tunnelfenster
- 24: Injektionsimplantation
- 26: Source/Drain-Anschlüsse
- 28: Steuer-Gate-Anschluß
- 40: Einsatzspannungskurve für große Pulshöhe
- 42: Einsatzspannungskurve für geringe Pulshöhe
- 44: Linie, die das Ende der ersten Phase anzeigt
- 50: Zeitmaßstabszelle
- 52: Referenzzelle
- 54: Steuereinrichtung
- 56: Ladungsinjektionseinrichtung
- 58: Zeiterfassungseinrichtung

## Patentansprüche

1. Zeiterfassungsvorrichtung mit folgenden Merkmalen:
einem Halbleiterelement (50) mit einer Transistorstruktur, das Source/Drain-Bereiche (2) und einen Kanalbereich (8) zwischen denselben, ein über dem Kanalbereich (8) angeordnetes Gate-Dielektrikum (10), eine über dem Gate-Dielektrikum (10) angeordnete Floating-Gate-Elektrode (12), eine über der Floating-Gate-Elektrode (12) angeordnete Schichtfolge, die eine auf der Floating-Gate-Elektrode (12) angeordnete Oxidschicht (16) und eine auf der Oxidschicht (16) angeordnete Nitridschicht (18) umfaßt, und eine über der Schichtfolge angeordnete Steuer-Gate-Elektrode (14) aufweist;
einer Ladungsinjektionseinrichtung (56) zum Injizieren von Ladungen in die Floating-Gate-Elektrode (12) und in die Nitridschicht (18), wobei sich ein Schwerpunkt der in die Nitridschicht (18) injizierten Ladungen an der Grenzfläche zwischen Oxidschicht (16) und Nitridschicht (18) der Schichtfolge befindet, über ein Anlegen einer Spannung oder von Spannungspulsen an die Steuer-Gate-Elektrode; **gekennzeichnet durch**
eine Einrichtung zum Erfassen einer seit dem Injizieren der Ladungen verstrichenen Zeit basierend auf Änderungen des Übertragungsverhaltens des Kanalbereichs (8), die **durch** eine Verschiebung des Schwerpunkts der Ladungen in der Nitridschicht (18) von der Grenzfläche weg bewirkt werden.

2. Zeiterfassungsvorrichtung nach Anspruch 1, bei der die Schichtfolge eine weitere Oxidschicht (20), die auf der Nitridschicht (18) angeordnet ist, aufweist.

3. Zeiterfassungsvorrichtung nach Anspruch 1 oder 2, die ferner ein Referenzhalbleiterelement (52) mit identischem Aufbau wie das Halbleiterelement (50) aufweist, wobei ferner eine Einrichtung zum Injizieren von Ladungen in die Floating-Gate-Elektrode des Referenzhalbleiterelements (52) gleichzeitig mit dem Injizieren von Ladungen in die Floating-Gate-Elektrode (12) und die Nitridschicht (18) des Halbleiterelements (50) vorgesehen ist, und wobei die Einrichtung (58) zum Erfassen der verstrichenen Zeit eine Einrichtung zum Vergleichen des Übertragungsverhaltens der Kanalbereiche des Halbleiterelements (50) und des Referenzhalbleiterelements (52) aufweist.

4. Zeiterfassungsvorrichtung nach Anspruch 1 oder 2, die ferner eine Einrichtung zum Erfassen der Spannung, die an die Steuer-Gate-Elektrode (14) angelegt werden muß, um einen vorbestimmten Stromfluß durch den Kanalbereich (8) des Halbleiterelements (50) zu bewirken, aufweist.

5. Zeiterfassungsvorrichtung nach Anspruch 3, die ferner eine Einrichtung zum Erfassen der Spannung, die an die Steuer-Gate-Elektroden des Halbleiterelements (50) und des Referenzhalbleiterelements (52) angelegt werden muß, um einen vorbestimmten Stromfluß durch den jeweiligen Kanalbereich zu bewirken, aufweist.

6. Verfahren zum Erfassen einer verstrichenen Zeit, mit folgenden Schritten:
Anlegen einer Spannung oder von Spannungspulsen an die Steuer-Gate-Elektrode (14) eines Halbleiterelements (50) mit einer Transistorstruktur, das Source/Drain-Bereiche (2), einen Kanalbereich (8) zwischen denselben, ein über dem Kanalbereich (8) angeordnetes Gate-Dielektrikum (10), eine über dem Gate-Dielektrikum (10) angeordnete Floating-Gate-Elektrode (12), eine über der Floating-Gate-Elektrode angeordnete Schichtfolge, die eine auf der Floating-Gate-Elektrode angeordnete Oxidschicht (16) und eine auf der Oxidschicht (16) angeordnete Nitridschicht (18) aufweist, und eine auf der Schichtfolge angeordnete Steuer-Gate-Elektrode (14) aufweist, zum Injizieren von Ladungen in die Floating-Gate-Elektrode (12) und in die Nitridschicht (18), wobei sich ein Schwerpunkt der in die Nitridschicht (18) injizierten Ladungen an der Grenzfläche zwischen der Oxidschicht (16) und der Nitridschicht (18) der Schichtfolge befindet; **gekennzeichnet durch** den Schritt des
Erfassens einer seit dem Induzieren der Ladungen verstrichenen Zeit basierend auf Änderungen des Übertragungsverhaltens des Kanalbereichs (8), die **durch** eine Verschiebung des Schwerpunkts der Ladungen in der Nitridschicht (18) von der Grenzfläche weg bewirkt werden.

7. Verfahren nach Anspruch 6, bei dem ein Halbleiterelement verwendet wird, bei dem die Schichtfolge über der Nitridschicht (18) eine weitere Oxidschicht (20) aufweist.

8. Verfahren nach Anspruch 6 oder 7, das ferner den Schritt des gleichzeitigen Injizierens von Ladungen in die Floating-Gate-Elektrode eines Referenzhalbleiterelements (52), das einen identischen Aufbau wie das Halbleiterelement (50) aufweist, umfaßt, wobei im Schritt des Erfassens der verstrichenen Zeit das Übertragungsverhalten der Kanalbereiche des Halbleiterelements (50) und des Referenzhalbleiterelements (52) verglichen werden.

9. Verfahren nach Anspruch 6 oder 7, das ferner den Schritt des Erfassens der Spannung, die an die Steuer-Gate-Elektrode (14) angelegt werden muß, um einen vorbestimmten Stromfluß durch den Kanalbereich (8) zu bewirken, aufweist.

10. Verfahren nach Anspruch 8, das ferner den Schritt des Erfassens der Spannung, die an die Steuer-Gate-Elektroden des Halbleiterelements (50) und des Referenzhalbleiterelements (52) angelegt werden muß, um einen vorbestimmten Stromfluß durch den jeweiligen Kanalbereich zu bewirken, aufweist.

## Claims

1. A time recording device comprising
a semiconductor element (50) with a transistor structure, which includes source/drain regions (2) and a channel region (8) between the same, a gate dielectric (10) arranged above the channel region (8), a floating gate electrode (12) arranged above the gate dielectric (10), a layer sequence comprising an oxide layer (16) arranged on the floating gate electrode (12) and a nitride layer (18) arranged on the oxide layer (16), the layer sequence being arranged above the floating gate electrode (12), and a control gate electrode (14) arranged above the layer sequence;
a charge injection unit (56) for injecting charges into the floating gate electrode (12) and into the nitride layer (18) by applying a voltage or voltage pulses to the control gate electrode, a centre of concentration of the charges injected into the nitride layer (18) being located at the interface between oxide layer (16) and nitride layer (18) of the layer sequence; **characterized by**
a unit for recording a time which has elapsed since charge injection on the basis of changes in the transmission behaviour of the channel region (8) caused by a shift in the centre of concentration of the charges in the nitride layer (18) away from the interface.

2. A time recording device according to claim 1, wherein the layer sequence has a further oxide layer (20) arranged on the nitride layer (18).

3. A time recording device according to claim 1 or 2, which also has a reference semiconductor element (52) with exactly the same structure as the semiconductor element (50), a unit for injecting charges into the floating gate electrode of the reference semiconductor element (52) at the same time as charges are injected into the floating gate electrode (12) and the nitride layer (18) of the semiconductor element (50) being provided as well and the unit (58) for recording the elapsed time having a unit for comparing the transmission behaviour of the channel regions of the semiconductor element (50) and the reference semiconductor element (52).

4. A time recording device according to claim 1 or 2, which also has a unit for recording the voltage which must be applied to the control gate electrode (14) in order to cause a specified current flow through the channel region (8) of the semiconductor element (50).

5. A time recording device according to claim 3, which also has a unit for recording the voltage which must be applied to the control gate electrodes of the semiconductor element (50) and of the reference semiconductor element (52) in order to cause a specified current flow through the respective channel region.

6. A method for recording an elapsed time, comprising the following steps:
applying a voltage or voltage pulses to the control gate electrode (14) of a semiconductor element (50) having a transistor structure, which includes source/drain regions (2); a channel region (8) between the same; a gate dielectric (10) arranged above the channel region (8); a floating gate electrode (12) arranged above the gate dielectric (10); a layer sequence comprising an oxide layer (16) arranged on the floating gate electrode and a nitride layer (18) arranged on the oxide layer (16), the layer sequence being arranged above the floating gate electrode; and a control gate electrode (14) arranged above the layer sequence, so as to inject charges into the floating gate electrode (12) and into the nitride layer (18), a centre of concentration of the charges injected into the nitride layer (18) being located at the interface between the oxide layer (16) and the nitride layer (18) of the layer sequence; **characterized by** the step of
recording a time which has elapsed since charge injection on the basis of changes in the transmission behaviour of the channel region (8) caused by a shift in the centre of concentration of the charges in the nitride layer (18) away from the interface.

7. A method according to claim 6, wherein a semiconductor element is used wherein the layer sequence has a further oxide layer (20) above the nitride layer (18).

8. A method according to claim 6 or 7, which also includes the step of simultaneous injection of charges into the floating gate electrode of a reference semiconductor element (52), the structure of which is identical to that of the semiconductor element (50), the transmission behaviour of the channel regions of the semiconductor element (50) and of the reference semiconductor element (52) being compared in the step of recording the elapsed time.

9. A method according to claim 6 or 7, which also includes the step of recording the voltage which must be applied to the control gate electrode (14) in order to causes a specified current flow through the channel region (8).

10. a method according to claim 8, which also includes the step of recording the voltage which must be applied to the control gate electrodes of the semiconductor element (50) and of the reference semiconductor element (52) in order to cause a specified current flow through the respective channel region.

## Revendications

1. Dispositif de détection du temps ayant les caractéristiques suivantes :
un élément (50) à semi-conducteur ayant une structure de transistor qui a des zones (2) de source/drain et une zone (8) de canal entre celles-ci, un diélectrique (10) de grille disposé au-dessus de la zone (8) de canal, une électrode (12) de grille flottante disposée au-dessus du diélectrique (10) de grille, une succession de couches qui est disposée au-dessus de l'électrode (12) de grille flottante et qui comprend une couche (16) d'oxyde disposée sur l'électrode (12) de grille flottante et une couche (18) de nitrure disposée sur la couche (16) d'oxyde et une électrode (14) de grille de commande disposée au-dessus de la succession de couches ;
un dispositif (56) d'injection de charge pour injecter des charges dans l'électrode (12) de grille flottante et dans la couche (18) de nitrure, un centre de gravité des charges injectées dans la couche (18) de nitrure se trouvant à l'interface entre la couche (16) d'oxyde et la couche (18) de nitrure de la succession de couches par une application d'une tension ou d'impulsions de tension à l'électrode de grille de commande ; **caractérisé par**
un dispositif de détection d'un temps écoulé depuis l'injection des charges reposant sur des variations du comportement de transmission de la zone (8) de canal qui sont provoquées par un déplacement du centre de gravité des charges de la couche (18) de nitrure les éloignant de l'interface.

2. Dispositif de détection du temps suivant la revendication 1, dans lequel la succession de couches a une autre couche (20) d'oxyde qui est disposée sur la couche (18) de nitrure.

3. Dispositif de détection du temps suivant la revendication 1 ou 2, qui a en outre un élément (52) à semi-conducteur de référence, de structure identique à l'élément (50) à semi-conducteur, un dispositif d'injection de charge étant en outre prévu dans l'électrode de grille flottante de l'élément (52) à semi-conducteur de référence, en même temps que l'injection de charge dans l'électrode (12) de grille flottante et dans la couche (18) de nitrure de l'élément (50) à semi-conducteur, et le dispositif (58) de détection du temps écoulé comporte un dispositif de comparaison du comportement de transmission des zones de canal de l'élément (50) à semi-conducteur et de l'élément (52) à semi-conducteur de référence.

4. Dispositif de détection du temps suivant la revendication 1 ou 2, qui a en outre un dispositif de détection de la tension qui doit être appliquée à l'électrode (14) de grille de commande pour provoquer un flux de courant déterminé à l'avance dans la zone (8) de canal de l'élément (50) à semi-conducteur.

5. Dispositif de détection du temps suivant la revendication 3, qui a en outre un dispositif de détection de la tension qui doit être appliquée aux électrodes de grille de commande de l'élément (50) à semi-conducteur et de l'élément (52) à semi-conducteur de référence pour provoquer un flux de courant déterminé à l'avance dans la zone de canal respective.

6. Procédé de détection d'un temps écoulé ayant les caractéristiques suivantes :
application d'une tension ou d'impulsions de tension à l'électrode (14) de grille de commande d'un élément (50) à semi-conducteur ayant une structure de transistor qui comporte des zones (2) de source/drain, une zone (8) de canal entre celles-ci, un diélectrique (10) de grille disposé au-dessus de la zone (8) de canal, une électrode (12) de grille flottante disposée au-dessus du diélectrique (10) de grille, une succession de couches disposées au-dessus de l'électrode de grille flottante qui a une couche (16) d'oxyde disposée sur l'électrode de grille flottante et une couche (18) de nitrure disposée sur la couche (16) d'oxyde, et une électrode (14) de grille de commande disposée sur la succession de couches pour l'injection de charge dans l'électrode (12) de grille flottante et dans la couche (18) de nitrure, un centre de gravité des charges injectées dans la couche (18) de nitrure se trouvant à l'interface entre la couche (16) d'oxyde et la couche (18) de nitrure de la succession de couches, **caractérisé par** le stade de
détection d'un temps écoulé depuis l'induction des charges reposant sur des variations du comportement de transmission de la zone (8) de canal qui est provoquée par un déplacement du centre de gravité des charges de la couche (18) de nitrure les éloignant de l'interface.

7. Procédé suivant la revendication 6, dans lequel on utilise un élément à semi-conducteur dans lequel la succession de couches a une autre couche (20) d'oxyde au-dessus de la couche (18) de nitrure.

8. Procédé suivant la revendication 6 ou 7, qui comprend en outre le stade d'injection simultanée de charges dans l'électrode de grille flottante d'un élément (52) à semi-conducteur de référence, de structure identique à l'élément (50) à semi-conducteur en comparant au stade de détection du temps écoulé le comportement de transmission des zones de canal de l'élément (50) à semi-conducteur et de l'élément (52) à semi-conducteur de référence.

9. Procédé suivant la revendication 6 ou 7, qui comprend en outre le stade de détection de la tension qui doit être appliquée à l'électrode (14) de grille de commande pour provoquer un flux de courant déterminé à l'avance dans la zone (8) de canal.

10. Procédé suivant la revendication 8, qui comprend en outre le stade de détection de la tension qui doit être appliquée aux électrodes de grille de commande de l'élément (50) à semi-conducteur et de l'élément (52) à semi-conducteur de référence pour provoquer un flux de courant déterminé à l'avance dans la zone de canal respective.
